# DEMANDE DE BREVET EUROPEEN

(11) **EP 2 854 180 A1**
(43) Date de publication de la demande: **01.04.2015**
(21) Numéro de dépôt: 14186271.4
(22) Date de dépôt: 24.09.2014
(51) Int. Cl.: H01L 29/49, H01L 29/51, H01L 29/66

(54) **Transistor MOS à espaceurs d'air**

(30) Priorité: 30.09.2013 FR 1359386
(71) Demandeur: COMMISSARIAT A L'ENERGIE ATOMIQUE ET AUX ENERGIES ALTERNATIVES, 75015 Paris (FR); STMicroelectronics (Crolles 2) SAS, 38920 Crolles (FR); STmicroelectronics SA, 92120 Montrouge (FR)
(72) Inventeur: Niebojewski, Heimanu, 98713 TAHITI-Polynésie Française (FR); Le Royer, Cyrille, 38210 TULLINS-FURES (FR); Morand, Yves, 38000 GRENOBLE (FR); Rozeau, Olivier, 38430 MOIRANS (FR)
(74) Mandataire: Thibon, Laurent

(57) **Abrégé**

L'invention concerne un transistor MOS dont la couche d'isolant de grille (10) en un matériau à forte constante diélectrique se prolonge, à épaisseur constante, sous et en contact d'espaceurs à faible constante diélectrique (7).

## Description

### Domaine

La présente invention concerne des transistors MOS et plus particulièrement des transistors MOS à espaceurs d'air.

### Exposé de l'art antérieur

Dans la réalisation d'un transistor MOS, on cherche de façon générale à réduire la consommation à la commutation et à augmenter la rapidité de commutation. Ces paramètres dépendent notamment des capacités grille-contact de source et grille-contact de drain.

Ces capacités parasites tendent à devenir particulièrement importantes dans le cas de transistors MOS de très petites dimensions dans lesquels les longueurs de grille sont inférieures à la centaine de nanomètres et notamment inférieures à 20 nm. En effet, dans ce cas les distances entre la grille, d'une part, le contact de source et le contact de drain, d'autre part, deviennent extrêmement faibles. Une solution pour réduire ces capacités parasites consiste à entourer les côtés de la grille de part et d'autre de la longueur de celle-ci d'espaceurs d'air (de vide) et non pas de façon classique d'espaceurs en un matériau diélectrique solide. Ceci est par exemple décrit dans l'article "Air Spacer MOSFET Technology for 20nm Node and Beyond" de Jemin Park et Chenming Hu 9th ICSICT - 20-23 octobre 2008 - IEEE 2008.

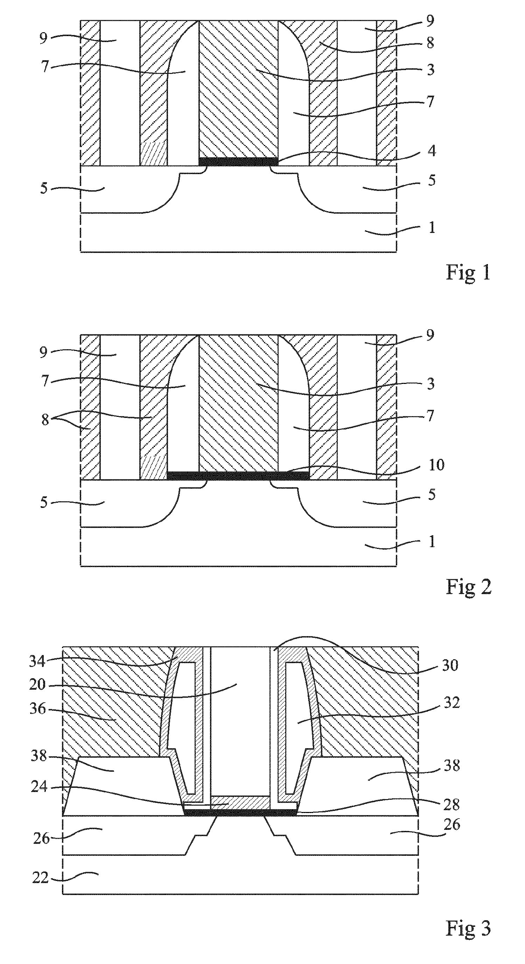

La figure 1 représente un transistor MOS formé sur un substrat semiconducteur 1 recouvert d'un empilement conducteur de grille 3 séparé du substrat par une couche d'isolant de grille 4 en un matériau à forte constante diélectrique. La source et le drain 5 sont disposés de part et d'autre de la grille dans le substrat. La grille est entourée d'espaceurs 7 en un matériau diélectrique à faible constante diélectrique. L'ensemble de l'empilement conducteur de grille et des espaceurs est entouré d'un isolant 8 au travers duquel sont réalisés des vias métalliques 9 réalisant les contacts de source et de drain.

L'article "Impacts of High-K Offset Spacer in 65-nm Node SOI Devices" de Ma Ming-Wen et al. - Electron Device Letters - 2007 et l'article "Impact of high-k dielectrics and spacer layers on the electrical performance of symmetrical double gâte MOSFETs" de Bhattacherjee S et Biswas A. - International Conférence on Emerging Trends in Electronic and Photonic Devices and Systems - 2009 enseignent que la valeur de la constante diélectrique du matériau des espaceurs influe sur les performances statiques du transistor MOS. En particulier, le fait de réduire la valeur de la constante diélectrique du matériau des espaceurs conduit à une détérioration de ces performances statiques en augmentant la tension de seuil et en diminuant la valeur du courant drain-source pour un couple de tension drain-source et de tension grille-source donné.

Il serait souhaitable de bénéficier à la fois des avantages des espaceurs en un matériau à faible constante diélectrique pour diminuer les capacités parasites, et des avantages des espaceurs en un matériau à forte constante diélectrique pour améliorer les performances statiques d'un transistor MOS.

### Résumé

Ainsi, un mode de réalisation prévoit un transistor MOS dont la couche d'isolant de grille en un matériau à forte constante diélectrique se prolonge, à épaisseur constante, sous et en contact d'espaceurs à faible constante diélectrique.

Selon un mode de réalisation, la couche d'isolant de grille en un matériau à forte constante diélectrique se prolonge sous toute l'étendue de la base des espaceurs à faible constante diélectrique.

Selon un mode de réalisation, les espaceurs à faible constante diélectrique sont des espaceurs d'air.

Selon un mode de réalisation, une couche de protection est présente entre l'espaceur d'air et l'ensemble formé de l'empilement conducteur de grille et de l'isolant de grille.

Selon un mode de réalisation, le transistor MOS comporte des bossages épitaxiés de drain et de source.

Selon un mode de réalisation, les contacts avec la source et le drain sont auto-alignés.

Selon un mode de réalisation, le transistor MOS est formé sur et dans un substrat en silicium sur isolant.

Un autre mode de réalisation prévoit un procédé de fabrication d'un transistor MOS comprenant les étapes suivantes :
a) déposer sur un substrat une couche d'isolant de grille à forte constante diélectrique ;
b) déposer successivement des matériaux qui constitueront un empilement conducteur de grille ;
c) délimiter l'empilement conducteur de grille en laissant en place l'isolant de grille ;
d) former autour de l'empilement conducteur de grille des premiers espaceurs à faible constante diélectrique ; et
e) graver l'isolant de grille en utilisant l'espaceur et l'empilement conducteur de grille comme masque.

Selon un mode de réalisation, le procédé comprend en outre entre les étapes c) et d) une étape consistant à déposer uniformément une couche de protection.

Selon un mode de réalisation, le procédé comprend après l'étape e) une étape consistant à former des bossages par épitaxie d'un matériau semiconducteur de part et d'autre de l'empilement conducteur de grille sur les régions exposées du substrat.

Selon un mode de réalisation, le procédé comprend en outre l'étape consistant à former des seconds espaceurs de part et d'autre des premiers espaceurs.

Selon un mode de réalisation le procédé comprend en outre les étapes suivantes :
recouvrir l'ensemble de la structure d'un matériau isolant sur une hauteur au moins égale à la hauteur de l'empilement conducteur de grille ;
aplanir la surface dudit matériau isolant de manière à découvrir le sommet des espaceurs ;
retirer par gravure les espaceurs pour former des espaceurs d'air ;
boucher l'ouverture supérieure des espaceurs d'air ; et
réaliser dans le matériau isolant recouvrant la structure des vias de contact métallique avec les régions de source et de drain.

Selon un mode de réalisation, le procédé comprend en outre les étapes suivantes :
recouvrir l'ensemble de la structure d'un métal ou d'un alliage métallique conducteur formant des contacts auto-alignés avec les régions de drain et de source ;
aplanir la surface du métal ou de l'alliage métallique de manière à découvrir le sommet des espaceurs ;
retirer par gravure les espaceurs pour former les espaceurs d'air ; et
boucher l'ouverture supérieure des espaceurs d'air.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe représentant un transistor MOS classique ;
la figure 2 est une vue en coupe représentant un mode de réalisation d'un transistor MOS ;
la figure 3 est une vue en coupe représentant un premier exemple de réalisation d'un transistor MOS à espaceurs d'air ;
la figure 4 est une vue en coupe représentant un second exemple de réalisation d'un transistor MOS à espaceurs d'air ;
les figures 5 à 11 sont des vues en coupe représentant des étapes successives de la fabrication du second exemple de réalisation d'un transistor MOS à espaceurs d'air ; et
la figure 12 est une vue en coupe représentant une étape de fabrication propre au premier exemple de réalisation d'un transistor MOS à espaceurs d'air.

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

### Description détaillée

La figure 2 représente de façon schématique une structure de transistor MOS dans laquelle de mêmes éléments qu'en figure 1 sont désignés par de mêmes références. Ainsi la figure 2 illustre un substrat 1, un empilement conducteur de grille 3, des régions de source et de drain 5, des espaceurs 7 en un matériau à faible constante diélectrique et des vias métalliques 9 de contact de source et de drain.

A la différence du transistor MOS de la figure 1, dans le transistor MOS de la figure 2, la couche d'isolant de grille 10 en un matériau à forte constante diélectrique est présente non seulement sous l'empilement conducteur de grille 3 mais aussi, à épaisseur constante, sous et en contact des espaceurs 7.

La présence d'un matériau à forte constante diélectrique 10 s'étendant au-delà de l'empilement de grille 3 et séparant les espaceurs 7 du substrat 1 confère au transistor MOS les performances statiques décrites comme associées à l'utilisation d'espaceurs en un matériau à forte constante diélectrique tout en conservant des capacités parasites réduites associées à l'utilisation d'espaceurs en un matériau à faible constante diélectrique.

Le brevet US 7812411 décrit un transistor MOS dans lequel un matériau à forte constante diélectrique est disposé sous des espaceurs d'air. La solution décrite et son procédé d'obtention sont extrêmement complexes.

La figure 3 représente de façon schématique un exemple particulier de réalisation d'un transistor MOS à espaceurs d'air du type de celui de la figure 2. Un empilement conducteur de grille 20, 24 est formé au-dessus d'un substrat 22. Cet empilement conducteur de grille 20, 24 est essentiellement constitué de silicium polycristallin dopé dans sa partie haute 20 et comporte dans sa partie basse, proche du substrat 22, une couche en un métal conducteur ou en un alliage métallique 24. De part et d'autre de l'empilement conducteur de grille 20, 24 des régions de drain et de source 26 sont formées dans le substrat 22. L'empilement conducteur de grille 20, 24 est séparé du substrat 22 par une couche d'isolant de grille 28 en un matériau à forte constante diélectrique. Cette couche d'isolant de grille 28 se prolonge, à épaisseur constante, à la surface du substrat 22 au-delà de l'empilement conducteur de grille 20, 24 de part et d'autre de celui-ci.

Une couche 30 en un matériau isolant est disposée le long de l'empilement de grille 20, 24 et au-dessus du prolongement de l'isolant de grille 28.

De part et d'autre de l'empilement conducteur de grille 20 sont formés des espaceurs d'air 32 délimités par une couche d'un matériau diélectrique 34, par exemple du nitrure de silicium. La couche 34 est séparée du substrat 22 par les deux couches de matériau 30 et 28, des prolongements de la couche 28 étant disposés sous toute l'étendue de la base des espaceurs d'air 32.

Au-delà des espaceurs d'air 32 se trouvent des régions de contact 36 avec le drain et la source 26. Dans l'exemple de réalisation illustré en figure 3, des régions 38 apparaissent au-dessus des régions de drain et de source 26. Les régions 38 sont des régions semiconductrices formées par épitaxie et destinées à épaissir les régions de drain et de source 26.

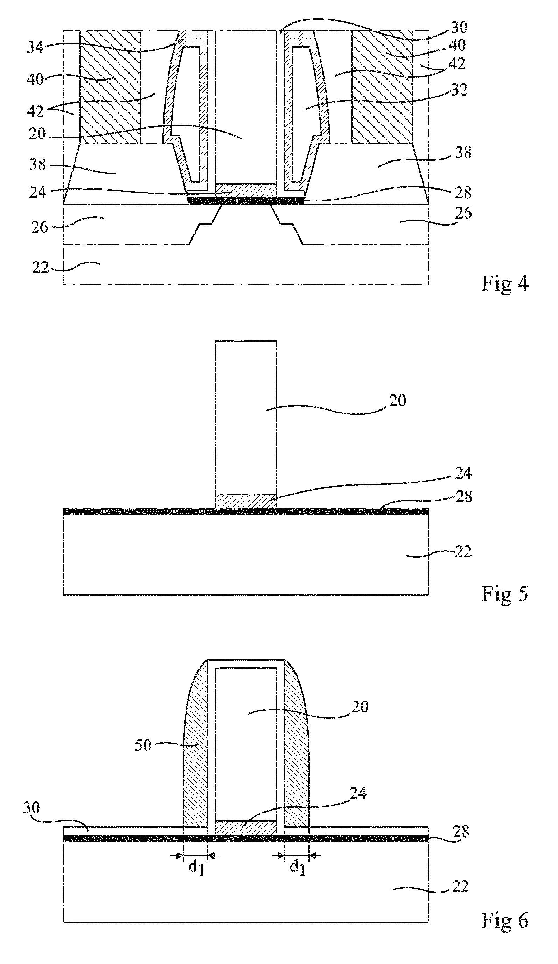

La figure 4 représente de façon schématique un autre exemple de réalisation d'un transistor à espaceurs d'air. Dans cette figure, de mêmes éléments qu'en figure 3 sont désignés par de mêmes références. La structure du transistor de la figure 4 comporte des régions 40 de contact avec la source et le drain. Les régions de contacts 40 sont formées de vias métalliques traversant un matériau isolant 42 enveloppant l'ensemble de l'empilement conducteur de grille 20, 24 et des espaceurs d'air 32. Le matériau isolant 42 s'étend au-delà des régions de contact 40 au-dessus du substrat 22.

Les figures 5 à 11 illustrent de façon schématique différentes étapes de fabrication du transistor MOS représenté en figure 3.

A l'étape illustrée en figure 5, l'empilement conducteur de grille 20, 24 a été formé sur la couche d'isolant de grille 28. Cette couche d'isolant de grille 28 en un matériau à forte constante diélectrique est présente sur toute la surface du substrat 22. La structure décrite est obtenue en déposant sur le substrat 22 une couche d'isolant de grille 28 sur laquelle sont déposés successivement des matériaux constituant l'empilement conducteur de grille 20, 24, puis en délimitant par gravure l'empilement conducteur de grille 20, 24. La gravure du métal 24 doit être sélective par rapport à celle de la couche d'isolant de grille 28.

La grille peut avoir une longueur comprise entre 10 et 30 nm. On considère ci-après à titre d'exemple une longueur de grille de 15 nm. La couche 28 peut être du HfSiON d'une épaisseur comprise entre 0,8 et 3 nm, typiquement 2 nm. Le substrat semiconducteur peut être en silicium, par exemple du silicium massif ou une couche mince de silicium sur isolant (SOI). L'empilement conducteur de grille 20, 24 peut être réalisé dans sa partie supérieure 20 en silicium polycristallin ou en SiGe polycristallin dopé. Cette partie supérieure peut avoir une hauteur de 10 à 50 nm, typiquement 30 nm. La couche métallique 24 de l'empilement conducteur de grille peut être en nitrure de titane (TiN) et d'une épaisseur comprise entre 2 et 10 nm, typiquement 5 nm.

A l'étape illustrée en figure 6, une couche d'isolant de protection 30 a été déposée de façon conforme sur l'ensemble de la structure. La couche 30 peut être formée par dépôt chimique en phase vapeur (CVD) ou dépôt de couches atomiques (ALD). La couche 30 peut être en nitrure de bore d'une épaisseur comprise entre 2 et 4 nm. Des espaceurs sacrificiels 50 ont été formés de part et d'autre de l'empilement conducteur de grille 20, 24. Les espaceurs sacrificiels 50 peuvent être en nitrure de silicium et présenter une dimension d1 à leur base comprise entre 3 et 9 nm. On notera que la gravure des espaceurs 50 doit être sélective par rapport à celle de la couche 30.

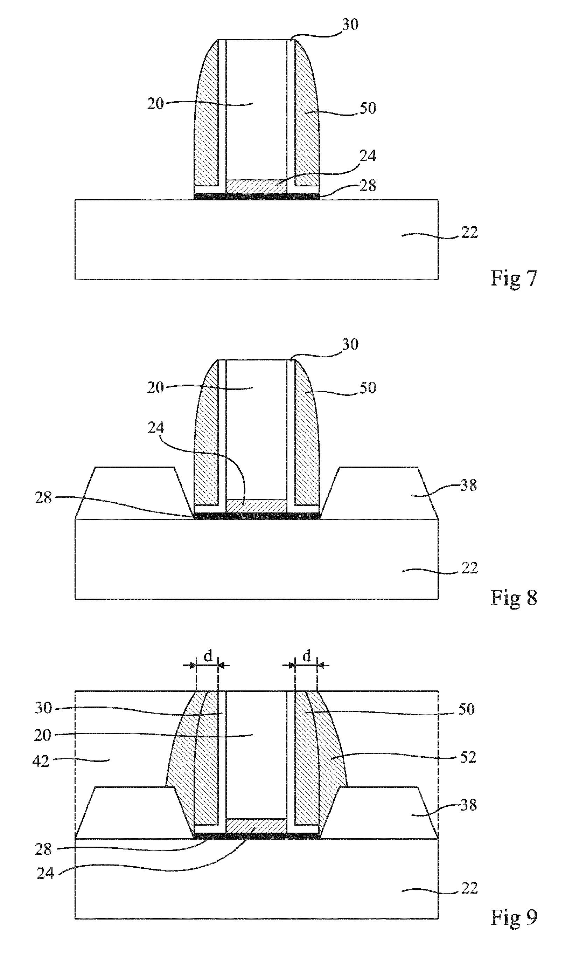

A l'étape illustrée en figure 7, des parties des couches d'isolant de grille 28 et de protection 30 qui s'étendaient au-delà des espaceurs sacrificiels 50 dans la structure représentée en figure 6 ont été supprimées par un procédé de gravure sèche. La gravure de l'isolant de grille 28 doit être sélective par rapport à celle du substrat 22. Ainsi, la couche 28, surmontée de la couche 30, demeure seulement sous l'empilement conducteur de grille 20, 24 et sous toute l'étendue des espaceurs sacrificiels 50.

La figure 8 illustre le résultat d'une étape d'épitaxie d'un matériau semiconducteur sur les parties exposées du substrat 22 pour former des bossages 38. Cette étape optionnelle est préférable en particulier dans le cas où le substrat 22 est une couche mince de silicium sur isolant (SOI).

A l'étape illustrée en figure 9, des espaceurs sacrificiels supplémentaires 52 ont été formés de part et d'autre des espaceurs sacrificiels 50. Ces espaceurs sacrificiels supplémentaires 52, en nitrure de silicium par exemple, débordent au-dessus d'une partie des régions 38. L'ensemble de la structure est recouvert d'un matériau isolant 42, de l'oxyde de silicium par exemple. Une étape de polissage mécano-chimique (CMP) est réalisée de manière à découvrir la partie haute des espaceurs sacrificiels 50 et 52 sur une longueur d.

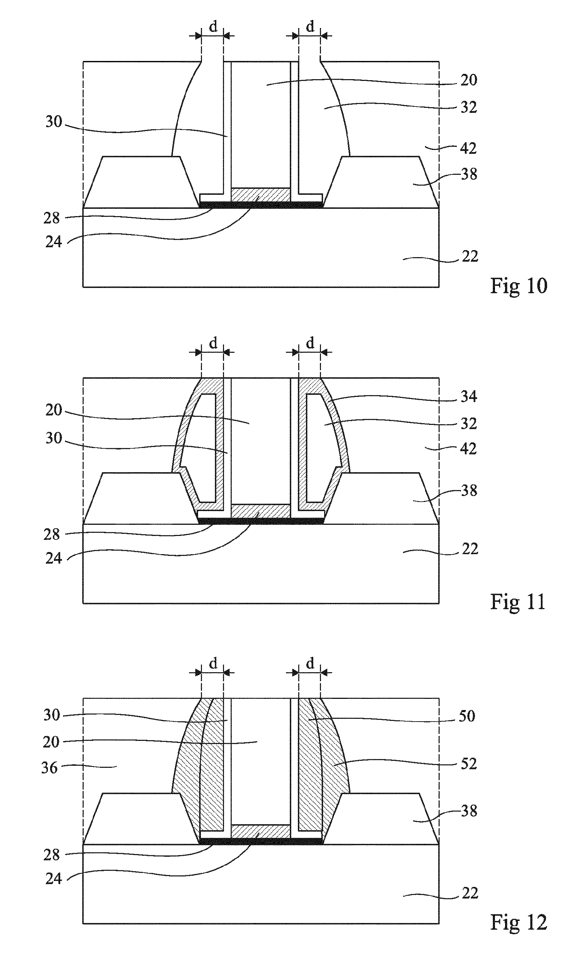

A l'étape illustrée en figure 10, les espaceurs sacrificiels 50 et 52 de la figure 9 ont été retirés par gravure sélective. La gravure doit être sélective par rapport à celles des matériaux de la couche 30, des régions 38 et de l'isolant 42 ainsi que du matériau 20 de l'empilement conducteur de grille 20, 24 (on aurait pu prévoir que ce dernier matériau soit recouvert d'une couche de masquage, non représentée). Pour des espaceurs 50 et 52 en nitrure de silicium, la gravure peut être réalisée avec de l'acide orthophosphorique (H₃PO₄).

A l'étape illustrée en figure 11, les ouvertures de longueur d présentes aux sommets des espaceurs d'air 32 ont été scellées par dépôt d'une couche de matériau diélectrique 34. Cette couche 34 est présente à la surface du matériau isolant 42 et sur les surfaces délimitant les espaceurs d'air 32. La partie de la couche 34 déposée au-dessus du matériau isolant 42 a été retirée, par exemple par polissage mécano-chimique (CMP).

A partir de la structure de la figure 11, on obtient la structure de transistor représentée en figure 4 en formant de façon classique des vias métalliques de contact 40 à travers le matériau isolant 42, au-dessus des régions 38.

Les figures 5 à 9 et la figure 12 illustrent de façon schématique différentes étapes de fabrication du transistor MOS représenté en figure 3.

A l'étape illustrée en figure 12, l'isolant 42 de la structure représentée en figure 9 a été retiré par gravure sélective. Un dépôt métallique 36 a ensuite été réalisé, par exemple du tungstène (W), du nitrure de titane (TiN) ou du nitrure de titane et de tungstène. L'épaisseur du dépôt 36 doit être au moins égale à la hauteur de l'empilement conducteur de grille 20, 24. L'ensemble de la structure est ensuite aplani par procédé de polissage mécano-chimique (CMP) afin de découvrir la partie supérieure des espaceurs sacrificiels 50 et 52 sur une longueur d. Le dépôt métallique 36 forme ainsi des contacts auto-alignés avec les régions 38.

Les matériaux des espaceurs sacrificiels 50 et 52 sont alors enlevés pour former des espaceurs d'air 32. Une couche de matériau diélectrique 34, en nitrure de silicium par exemple, est ensuite déposée sur le métal 36 et sur les surfaces délimitant les espaceurs d'air 32. Cette couche 34 assure le scellement des ouvertures de longueur d présentes aux sommets des espaceurs d'air 32. La partie de la couche 34 présente au-dessus du métal 36 est ensuite retirée par un procédé de polissage mécano-chimique (CMP).

Des modes de réalisation particuliers ont été décrits. Diverses variantes et modifications apparaîtront à l'homme de l'art.

En particulier, le substrat 22 peut correspondre à une couche mince de silicium sur isolant (SOI) ou être un substrat de silicium massif. Des régions de drain et de source 26 pourront être réalisées par des étapes classiques d'implantation. Une première étape d'implantation sera réalisée après formation de l'empilement de grille 20, 24 dans la structure représentée en figure 5. Une seconde étape d'implantation sera réalisée après formation des espaceurs sacrificiels 50.

Les matériaux décrits précédemment l'ont été à titre d'exemple et l'homme de l'art pourra les remplacer par des matériaux ayant de mêmes caractéristiques électriques et de sélectivité mutuelle de gravure. De même, les dimensions énoncées précédemment ont été indiquées à titre d'exemple et pourront être adaptées aux filières technologiques utilisées.

Bien que l'on ait décrit ici un procédé de fabrication où l'empilement conducteur de grille 20, 24 initial est définitif, cet empilement de grille initial pourra être éliminé en fin de processus et remplacé par un autre empilement conducteur de grille.

Diverses couches de protection ou d'arrêt de gravure pourront être ajoutées ou supprimées. En particulier, la présence de la couche de protection 30 peut être optionnelle.

## Revendications

1. Transistor MOS dont la couche d'isolant de grille (10) en un matériau à forte constante diélectrique se prolonge, à épaisseur constante, sous et en contact d'espaceurs d'air (32) délimités par une couche d'un matériau diélectrique (34).

2. Transistor MOS selon la revendication 1, dans lequel la couche d'isolant de grille (10) en un matériau à forte constante diélectrique se prolonge sous toute l'étendue de la base des espaceurs d'air.

3. Transistor MOS selon la revendication 1, dans lequel une couche de protection (30) est présente entre la couche en matériau diélectrique délimitant l'espaceur d'air (32) et l'ensemble formé de l'empilement conducteur de grille (20, 24) et de l'isolant de grille (28).

4. Transistor MOS selon l'une quelconque des revendications 1 à 3, comportant des bossages épitaxiés (38) de drain et de source (26).

5. Transistor MOS selon l'une quelconque des revendications 1 à 4, dans lequel les contacts avec la source et le drain sont auto-alignés (36).

6. Transistor MOS selon l'une quelconque des revendications 1 à 5, formé sur et dans un substrat en silicium sur isolant (22).

7. Procédé de fabrication d'un transistor MOS comprenant les étapes suivantes :
a) déposer sur un substrat (22) une couche d'isolant de grille (28) à forte constante diélectrique ;
b) déposer successivement des matériaux qui constitueront un empilement conducteur de grille (20, 24) ;
c) délimiter l'empilement conducteur de grille en laissant en place l'isolant de grille (28) ;
d) former autour de l'empilement conducteur de grille (20, 24) des premiers espaceurs sacrificiels (50) ; et
e) graver l'isolant de grille en utilisant les premiers espaceurs (50) et l'empilement conducteur de grille (20, 24) comme masque.

8. Procédé selon la revendication 7, comprenant en outre entre les étapes c) et d) une étape consistant à déposer uniformément une couche de protection (30).

9. Procédé selon la revendication 7 ou 8, comprenant après l'étape e) une étape consistant à former des bossages (38) par épitaxie d'un matériau semiconducteur de part et d'autre de l'empilement conducteur de grille (20, 24) sur les régions exposées du substrat (22).

10. Procédé selon l'une quelconque des revendications 7 à 9, comprenant en outre l'étape consistant à former des seconds espaceurs (52) de part et d'autre des premiers espaceurs (50).

11. Procédé selon l'une quelconque des revendications 8 à 10, comprenant en outre les étapes suivantes :
recouvrir l'ensemble de la structure d'un matériau isolant (42) sur une hauteur au moins égale à la hauteur de l'empilement conducteur de grille (20, 24) ;
aplanir la surface dudit matériau isolant (42) de manière à découvrir le sommet des espaceurs (50, 52) ;
retirer par gravure les espaceurs (50, 52) pour former des espaceurs d'air (32) ;
boucher l'ouverture supérieure des espaceurs d'air (32) ; et
réaliser dans le matériau isolant (42) recouvrant la structure des vias de contact métallique (40) avec les régions de source et de drain (26).

12. Procédé selon l'une quelconque des revendications 8 à 10, comprenant en outre les étapes suivantes :
recouvrir l'ensemble de la structure d'un métal ou d'un alliage métallique conducteur (36) formant des contacts auto-alignés avec les régions de drain et de source (26) ;
aplanir la surface du métal ou de l'alliage métallique (36) de manière à découvrir le sommet des espaceurs (50, 52) ;
retirer par gravure les espaceurs (50, 52) pour former les espaceurs d'air (32) ; et
boucher l'ouverture supérieure des espaceurs d'air (32).
